(19) Europäisches Patentamt / European Patent Office / Office européen des brevets

(11) **EP 3 767 677 A1**

(12) **DEMANDE DE BREVET EUROPEEN**

(43) Date de publication:
**20.01.2021 Bulletin 2021/03**

(51) Int Cl.:
*H01L 27/30* (2006.01)  *H01L 51/44* (2006.01)
*H04N 5/369* (2011.01)  *H01L 27/146* (2006.01)

(21) Numéro de dépôt: **20186097.0**

(22) Date de dépôt: **16.07.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **19.07.2019 FR 1908251**

(71) Demandeur: **ISORG**
**87068 Limoges Cedex 3 (FR)**

(72) Inventeurs:
• DUPOIRON, Camille
 **38000 GRENOBLE (FR)**
• BOUTHINON, Benjamin
 **38000 GRENOBLE (FR)**

(74) Mandataire: **Cabinet Beaumont**
 **4, Place Robert Schuman**
 **B.P. 1529**
 **38025 Grenoble Cedex 1 (FR)**

(54) **PIXEL DE CAPTEUR D'IMAGES**

(57) La présente description concerne un pixel comportant un support CMOS (3) et au moins deux photodétecteurs organiques (10A, 10B, 12A, 12B, 14A, 14B, 16A, 16B), dans lequel une même lentille (18) est à l'aplomb desdits photodétecteurs organiques.

Fig. 1

EP 3 767 677 A1

**Description**

Domaine technique

La présente demande concerne un capteur d'images ou imageur électronique.

Technique antérieure

Des capteurs d'images sont actuellement utilisés dans de nombreux domaines, en particulier dans les dispositifs électroniques. On retrouve notamment des capteurs d'images dans des applications d'interface homme-machine et de prise d'images. Des domaines d'utilisation de tels capteurs d'images sont, par exemple, les téléphones intelligents, l'automobile, les drones, la robotique et les systèmes à réalité virtuelle ou augmentée.

Dans certaines applications, un même dispositif électronique peut disposer de plusieurs capteurs d'images de différents types. Un tel dispositif peut ainsi comporter, par exemple, un premier capteur d'images en couleur, un deuxième capteur d'images infrarouge, un troisième capteur d'images permettant d'évaluer une distance, par rapport au dispositif, de différents points d'une scène ou d'un sujet, etc.

Cette multiplicité de capteurs d'images embarqués dans un même dispositif est, par nature, peu compatible avec les contraintes actuelles de miniaturisation de ces dispositifs.

Le document DE102016102111 décrit un capteur d'images et un dispositif d'imagerie comportant ce capteur.

Le document US2017257587 décrit un dispositif d'imagerie à semiconducteur, un procédé de commande de ce dispositif et un dispositif électronique.

Le document US2013182173 décrit un dispositif d'imagerie à semiconducteur et un appareil photographique.

Le document US2016105622 décrit un dispositif d'imagerie.

Le document EP3209012 décrit un dispositif électronique et son procédé de fonctionnement.

Résumé de l'invention

Il existe un besoin d'améliorer les capteurs d'images existants.

Un mode de réalisation pallie tout ou partie des inconvénients des capteurs d'images connus.

Un mode de réalisation prévoit un pixel comportant :

un support CMOS ; et
au moins deux photodétecteurs organiques,
dans lequel une même lentille est à l'aplomb desdits photodétecteurs organiques.

Un mode de réalisation prévoit un capteur d'images comportant plusieurs pixels tels que décrits.

Un mode de réalisation prévoit un procédé de fabrication d'un tel pixel ou d'un tel capteur d'images, comprenant des étapes consistant à :

prévoir un support CMOS ;
réaliser au moins deux photodétecteurs organiques par pixel ; et
réaliser une même lentille à l'aplomb des photodétecteurs organiques du ou de chaque pixel.

Selon un mode de réalisation, lesdits photodétecteurs organiques sont coplanaires.

Selon un mode de réalisation, lesdits photodétecteurs organiques sont séparés les uns des autres par un diélectrique.

Selon un mode de réalisation, chaque photodétecteur organique comporte une première électrode, distincte de premières électrodes des autres photodétecteurs organiques, formée en surface du support CMOS.

Selon un mode de réalisation, chaque première électrode est reliée, de préférence connectée, à un circuit de lecture, chaque circuit de lecture comportant, de préférence, trois transistors formés dans le support CMOS.

Selon un mode de réalisation, lesdits photodétecteurs organiques sont adaptés à évaluer une distance par temps de vol.

Selon un mode de réalisation, le pixel ou le capteur tel que décrit est adapté à fonctionner :

dans une partie du spectre infrarouge ;
en lumière structurée ;
en imagerie à grande gamme dynamique, HDR ;
et/ou avec suppression de fond.

Selon un mode de réalisation, chaque pixel comporte en outre, sous la lentille, un filtre couleur laissant passer les ondes électromagnétiques dans une plage de fréquences du spectre visible et dans le spectre infrarouge.

Selon un mode de réalisation, le capteur tel que décrit est adapté à capter une image couleur.

Selon un mode de réalisation, chaque pixel comporte exactement :

un premier photodétecteur organique ; et
un deuxième photodétecteur organique.

Selon un mode de réalisation, pour chaque pixel, le premier photodétecteur organique et le deuxième photodétecteur organique sont de forme rectangulaire et s'inscrivent conjointement dans un carré.

Selon un mode de réalisation, pour chaque pixel :

le premier photodétecteur organique est connecté à une deuxième électrode ; et
le deuxième photodétecteur organique est connecté à une troisième électrode.

Un mode de réalisation prévoit un capteur dans lequel :

la deuxième électrode est commune à tous les premiers photodétecteurs organiques des pixels du capteur ; et
la troisième électrode est commune à tous les deuxièmes photodétecteurs organiques des pixels du capteur.

Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :

La figure 1 est une vue en perspective éclatée, schématique et partielle, d'un mode de réalisation d'un capteur d'images ;

La figure 2 est une vue de dessus, schématique et partielle, du capteur d'images de la figure 1 ;

La figure 3 est un schéma électrique d'un mode de réalisation de circuits de lecture de deux pixels du capteur d'images des figures 1 et 2 ;

La figure 4 est un chronogramme de signaux d'un exemple de fonctionnement du capteur d'images ayant les circuits de lecture de la figure 3 ;

La figure 5 est une vue en coupe, schématique et partielle, d'une étape d'un mode de mise en œuvre d'un procédé de réalisation du capteur d'images des figures 1 et 2 ;

La figure 6 est une vue en coupe, schématique et partielle, d'une autre étape du mode de mise en œuvre du procédé de réalisation du capteur d'images des figures 1 et 2 ;

La figure 7 est une vue en coupe, schématique et partielle, d'encore une autre étape du mode de mise en œuvre du procédé de réalisation du capteur d'images des figures 1 et 2 ;

La figure 8 est une vue en coupe, schématique et partielle, d'encore une autre étape du mode de mise en œuvre du procédé de réalisation du capteur d'images des figures 1 et 2 ;

La figure 9 est une vue en coupe, schématique et partielle, d'encore une autre étape du mode de mise en œuvre du procédé de réalisation du capteur d'images des figures 1 et 2 ;

La figure 10 est une vue en coupe, schématique et partielle, d'encore une autre étape du mode de mise en œuvre du procédé de réalisation du capteur d'images des figures 1 et 2 ;

La figure 11 est une vue en coupe, schématique et partielle, d'une variante du mode de mise en œuvre du procédé de réalisation du capteur d'images des figures 1 et 2 ;

La figure 12 est une vue en coupe, schématique et partielle, d'encore une autre étape du mode de mise en œuvre du procédé de réalisation du capteur d'images des figures 1 et 2 ;

La figure 13 est une vue en coupe, schématique et partielle, d'encore une autre étape du mode de mise en œuvre du procédé de réalisation du capteur d'images des figures 1 et 2 ;

La figure 14 est une vue en coupe selon le plan AA, schématique et partielle, du capteur d'images des figures 1 et 2 ;

La figure 15 est une vue en coupe selon le plan BB, schématique et partielle, du capteur d'images des figures 1 et 2 ; et

La figure 16 est une vue en coupe, schématique et partielle, d'un autre mode de réalisation d'un capteur d'images.

Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.
Par souci de clarté, seuls les étapes et éléments utiles à la compréhension des modes de réalisation et modes de mise en œuvre décrits ont été représentés et sont détaillés. En particulier, l'utilisation faite des capteurs d'images décrits ci-après n'a pas été détaillée.
Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

De plus, on appelle « signal binaire » un signal qui alterne entre un premier état constant, par exemple un état bas, noté « 0 », et un deuxième état constant, par exemple un état haut, noté « 1 ». Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas.

Dans la suite de la description, on considère, sauf mention contraire, que les termes « isolant » et « conducteur » signifient respectivement « isolant électriquement » et « conducteur électriquement ».

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un capteur d'images dans une position normale d'utilisation.

Sauf précision contraire, les expressions "environ", "approximativement", "sensiblement", et "de l'ordre de" signifient à 10 % près, de préférence à 5 % près.

La transmittance d'une couche à un rayonnement correspond au rapport entre l'intensité du rayonnement sortant de la couche et l'intensité du rayonnement entrant dans la couche, les rayons du rayonnement entrant étant perpendiculaires à la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,7 μm.

Un pixel d'une image correspond à l'élément unitaire de l'image captée par un capteur d'images. Lorsque le dispositif optoélectronique est un capteur d'images couleur, il comprend en général, pour chaque pixel de l'image couleur à acquérir, au moins trois composants. Ces trois composants font chacun l'acquisition d'un rayonnement lumineux sensiblement dans une seule couleur, c'est-à-dire dans une plage de longueurs d'onde de largeur inférieure à 130 nm (par exemple, le rouge, le vert et le bleu). Chaque composant peut comprendre notamment au moins un photodétecteur.

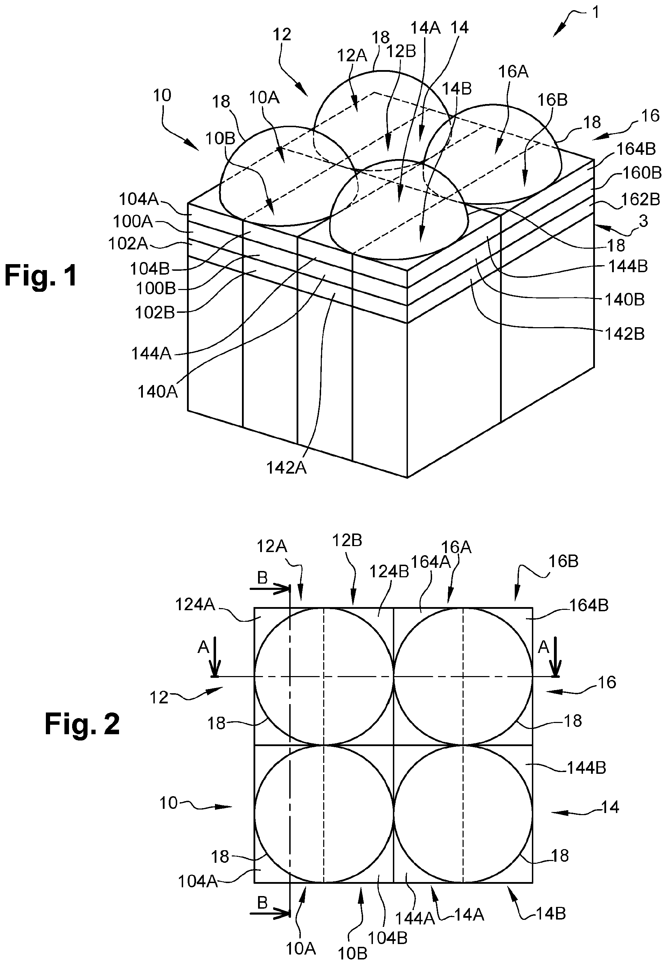

La figure 1 est une vue en perspective éclatée, schématique et partielle, d'un mode de réalisation d'un capteur d'images 1.

Ce capteur d'images 1 comporte une matrice de pixels coplanaires. Pour simplifier, seuls quatre pixels 10, 12, 14 et 16 du capteur d'images 1 ont été représentés en figure 1 étant entendu que, en pratique, le capteur d'images 1 peut comporter davantage de pixels. Le capteur d'images 1 comporte, par exemple, plusieurs millions voire plusieurs dizaines de millions de pixels.

Selon ce mode de réalisation, les pixels 10, 12, 14 et 16 sont situés en surface d'un support CMOS 3, par exemple un morceau de plaquette de silicium sur et à l'intérieur duquel des circuits intégrés (non représentés) ont été réalisés en technologie CMOS (Complementary Metal Oxide Semiconductor). Ces circuits intégrés forment, dans cet exemple, une matrice de circuits de lecture associés aux pixels 10, 12, 14 et 16 du capteur d'images 1. Par circuit de lecture, on entend un ensemble de transistors de lecture, d'adressage et de commande associés à chaque pixel.

Dans le capteur d'images 1, chaque pixel comporte un premier photodétecteur, repéré par le suffixe « A », et un deuxième photodétecteur, repéré par le suffixe « B ». Plus précisément, dans l'exemple de la figure 1 :

le pixel 10 comporte un premier photodétecteur 10A et un deuxième photodétecteur 10B ;
le pixel 12 comporte un premier photodétecteur 12A et un deuxième photodétecteur 12B ;
le pixel 14 comporte un premier photodétecteur 14A et un deuxième photodétecteur 14B ; et
le pixel 16 comporte un premier photodétecteur 16A et un deuxième photodétecteur 16B.

Ces photodétecteurs 10A, 10B, 12A, 12B, 14A, 14B, 16A et 16B peuvent correspondre à des photodiodes organiques (Organic Photodiode - OPD) ou à des photorésistances organiques. Dans la suite de la description, on considère que les photodétecteurs des pixels du capteur d'images 1 correspondent à des photodiodes organiques.

Dans la représentation simplifiée de la figure 1, chaque photodétecteur comporte une couche active comprise ou en « sandwich » entre deux électrodes. Plus précisément, dans l'exemple de la figure 1 où seules des faces latérales des photodétecteurs organiques 10A, 10B, 14A, 14B et 16B sont visibles :

le premier photodétecteur 10A est constitué d'une couche active 100A comprise entre une première électrode 102A et une deuxième électrode 104A ;
le deuxième photodétecteur 10B est constitué d'une couche active 100B comprise entre une première électrode 102B et une deuxième électrode 104B ;
le premier photodétecteur 14A est constitué d'une couche active 140A comprise entre une première électrode 142A et une deuxième électrode 144A ;

le deuxième photodétecteur 14B est constitué d'une couche active 140B comprise entre une première électrode 142B et une deuxième électrode 144B ; et le deuxième photodétecteur 16B est constitué d'une couche active 160B comprise entre une première électrode 162B et une deuxième électrode 164B.

De la même façon, dans le capteur d'images 1 :

le premier photodétecteur 12A est constitué d'une couche active 120A (non visible en figure 1) comprise entre une première électrode 122A (non visible en figure 1) et une deuxième électrode 124A (non visible en figure 1) ;
le deuxième photodétecteur 12B est constitué d'une couche active 120B (non visible en figure 1) comprise entre une première électrode 122B (non visible en figure 1) et une deuxième électrode 124B (non visible en figure 1) ; et
le premier photodétecteur 16A est constitué d'une couche active 160A (non visible en figure 1) comprise entre une première électrode 162A (non visible en figure 1) et une deuxième électrode 164A (non visible en figure 1).

Dans la suite de la description, les premières électrodes seront également désignées par l'expression « électrodes inférieures » tandis que les deuxièmes électrodes seront également désignées par l'expression « électrodes supérieures ».

Selon un mode de réalisation, l'électrode supérieure de chaque photodétecteur organique constitue une électrode d'anode tandis que l'électrode inférieure de chaque photodétecteur organique constitue une électrode de cathode.

L'électrode inférieure de chaque photodétecteur de chaque pixel du capteur d'images 1 est individuellement reliée, de préférence connectée, à un circuit de lecture (non représenté) du support CMOS 3. Chaque photodétecteur du capteur d'images 1 est par conséquent adressé de façon individuelle par son électrode inférieure. Ainsi, dans le capteur d'images 1, chaque photodétecteur possède une électrode inférieure distincte des électrodes inférieures de tous les autres photodétecteurs. En d'autres termes, chaque photodétecteur d'un pixel possède une électrode inférieure distincte :

de l'autre photodétecteur du même pixel ; et
des autres photodétecteurs des autres pixels.

Toujours dans le capteur d'images 1, les électrodes supérieures de tous les premiers photodétecteurs sont interconnectées. De la même manière, les électrodes supérieures de tous les deuxièmes photodétecteurs sont interconnectées. Ainsi, dans la représentation simplifiée de la figure 1 :

les électrodes supérieures 104A, 124A, 144A et 164A, appartenant respectivement aux premiers photodétecteurs 10A, 12A, 14A et 16A, sont interconnectées ou forment une première électrode supérieure commune ; et
les électrodes supérieures 104B, 124B, 144B et 164B, appartenant respectivement aux premiers photodétecteurs 10B, 12B, 14B et 16B, sont interconnectées ou forment une deuxième électrode supérieure commune, distincte de la première électrode supérieure commune.

Dans le capteur d'images 1, chaque pixel comporte une lentille 18, également appelée microlentille 18 en raison de ses dimensions. Ainsi, dans la représentation simplifiée de la figure 1 les pixels 10, 12, 14 et 16 comportent chacun une lentille 18. Chaque lentille 18 recouvre ainsi tout ou partie des premier et deuxième photodétecteurs de chaque pixel du capteur d'images 1. Plus précisément, la lentille 18 recouvre physiquement les électrodes supérieures des premier et deuxième photodétecteurs du pixel.

La figure 2 est une vue de dessus, schématique et partielle, du capteur d'images 1 de la figure 1.

Dans cette vue de dessus, on a représenté les premiers et deuxièmes photodétecteurs par des rectangles et les microlentilles par des cercles. Plus précisément, en figure 2 :

une microlentille 18 recouvre l'électrode supérieure 104A, respectivement 104B, du photodétecteur 10A, respectivement 10B, du pixel 10 ;
une microlentille 18 recouvre l'électrode supérieure 124A, respectivement 124B, du photodétecteur 12A, respectivement 12B, du pixel 12 ;
une microlentille 18 recouvre l'électrode supérieure 144A, respectivement 144B, du photodétecteur 14A, respectivement 14B, du pixel 14 ; et
une microlentille 18 recouvre l'électrode supérieure 164A, respectivement 164B, du photodétecteur 16A, respectivement 16B, du pixel 16.

En pratique, grâce aux intervalles entre électrodes qui ressortiront de l'exposé des figures suivantes, on peut considérer que les lentilles 18 recouvrent totalement les électrodes respectives des pixels auxquels elles sont associées.

Dans le capteur d'images 1, vu de dessus en figure 2, les pixels sont sensiblement de forme carrée, de préférence de forme carrée. Tous les pixels du capteur d'images 1 présentent préférentiellement des dimensions identiques, aux dispersions de fabrication près.

Le carré formé par chaque pixel du capteur d'images 1, vu de dessus en figure 2, a un côté compris entre environ 0,8 $\mu$m et 10 $\mu$m, de préférence compris entre environ 0,8 $\mu$m et 3 $\mu$m, encore plus préférentiellement compris entre 0,8 $\mu$m et 3 $\mu$m.

Le premier photodétecteur et le deuxième photodétecteur appartenant à un même pixel (par exemple, le premier photodétecteur 10A et le deuxième photodétecteur 10B du premier pixel 10) sont tous deux de forme rectangulaire. Ces photodétecteurs possèdent sensiblement les mêmes dimensions et s'inscrivent conjointement dans le carré formé par le pixel auquel ils appartiennent.

Le rectangle formé par chaque photodétecteur de chaque pixel du capteur d'images 1 a une longueur sensiblement égale au côté du carré formé par chaque pixel et une largeur sensiblement égale à la moitié du côté du carré formé par chaque pixel. Un espace est toutefois ménagé entre le premier et le deuxième photodétecteur de chaque pixel, de telle sorte que leurs électrodes inférieures respectives sont disjointes.

Dans le capteur d'images 1, chaque microlentille 18 présente, vue de dessus en figure 2, un diamètre sensiblement égal, de préférence égal, au côté du carré formé par le pixel auquel elle appartient. Dans le présent mode de réalisation, chaque pixel comporte une microlentille 18. Chaque microlentille 18 du capteur d'images 1 est, de préférence, centrée par rapport au carré formé par les photodétecteurs qu'elle recouvre.

À titre de variante, chaque microlentille 18 peut être remplacée par un autre type d'élément optique de taille micrométrique, notamment une lentille de Fresnel de taille micrométrique, une lentille à gradient d'indice de taille micrométrique ou un réseau de diffraction de taille micrométrique. Les microlentilles 18 sont des lentilles convergentes ayant chacune une distance focale f comprise entre 1 $\mu$m et 100 $\mu$m, de préférence entre 1 $\mu$m et 10 $\mu$m. Selon un mode de réalisation, toutes les microlentilles 18 sont sensiblement identiques.

Les microlentilles 18 peuvent être réalisées en silice, en polyméthacrylate de méthyle (PMMA), en une résine photosensible positive, en polyéthylène téréphtalate (PET), en polyéthylène naphtalate (PEN), en copolymère cyclo-oléfine (COP), en polydiméthylsiloxane (PDMS)/silicone, ou en résine époxy. Les microlentilles 18 peuvent être formées par fluage de blocs d'une résine photosensible. Les microlentilles 18 peuvent en outre être formées par moulage sur une couche de PET, PEN, COP, PDMS/silicone ou résine époxy.

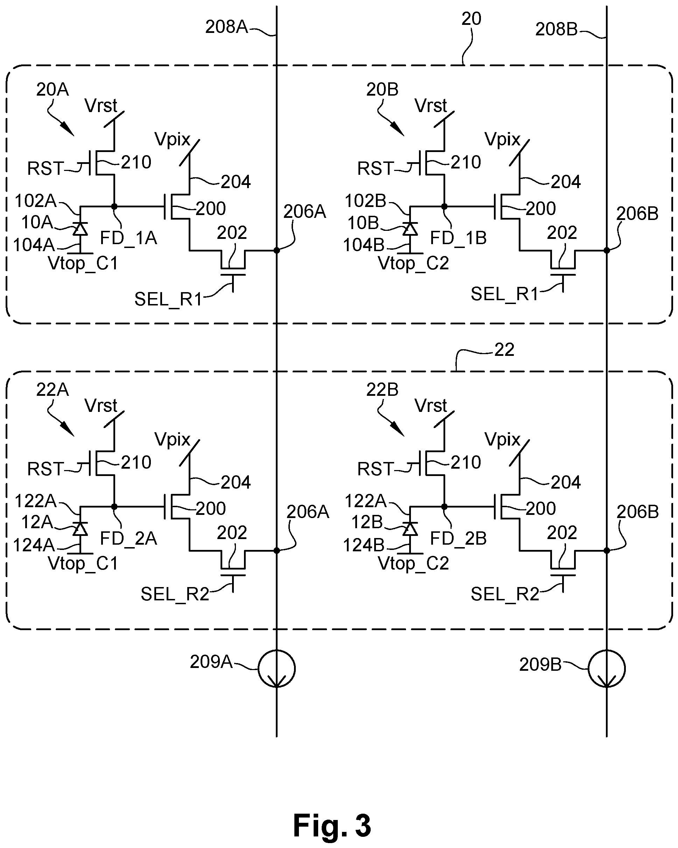

La figure 3 est un schéma électrique d'un mode de réalisation de circuits de lecture de deux pixels du capteur d'images des figures 1 et 2.

Pour simplifier, on ne s'intéresse en figure 3 qu'aux circuits de lecture associés à deux pixels du capteur d'images 1, par exemple les pixels 10 et 12 du capteur d'images 1. Dans cet exemple, chaque photodétecteur est associé à un circuit de lecture. Plus précisément, en figure 3 :

le premier photodétecteur 10A du pixel 10 est associé à un premier circuit de lecture 20A ;
le deuxième photodétecteur 10B du pixel 10 est associé à un deuxième circuit de lecture 20B ;
le premier photodétecteur 12A du pixel 12 est associé à un premier circuit de lecture 22A ; et
le deuxième photodétecteur 12B du pixel 12 est associé à un deuxième circuit de lecture 22B.

Le premier circuit de lecture 20A du premier photodétecteur 10A du pixel 10 et le deuxième circuit de lecture 20B du deuxième photodétecteur 10B du pixel 10 forment conjointement un circuit de lecture 20 du pixel 10. De la même façon, le premier circuit de lecture 22A du premier photodétecteur 12A du pixel 12 et le deuxième circuit de lecture 22B du deuxième photodétecteur 12B du pixel 12 forment conjointement un circuit de lecture 22 du pixel 12.

Selon ce mode de réalisation, chaque circuit de lecture 20A, 20B, 22A, 22B comprend trois transistors MOS. Un tel circuit est couramment désigné, avec son photodétecteur, par l'expression « capteur 3T ». En particulier, dans l'exemple de la figure 3, chaque circuit de lecture 20A, 22A associé à un premier photodétecteur comporte un transistor MOS en montage suiveur 200, en série avec un transistor MOS de sélection 202, entre deux bornes 204 et 206A. De la même façon, toujours dans l'exemple de la figure 3, chaque circuit de lecture 20B, 22B associé à un deuxième photodétecteur comporte un transistor MOS en montage suiveur 200, en série avec un transistor MOS de sélection 202, entre deux bornes 204 et 206B.

Chaque borne 204 est reliée à une source d'un potentiel de référence haut, noté Vpix, dans le cas où les transistors des circuits de lecture sont des transistors MOS à canal N. Chaque borne 204 est reliée à une source d'un potentiel de référence bas, par exemple la masse, dans le cas où les transistors des circuits de lecture sont des transistors MOS à canal P.

Chaque borne 206A est reliée à une première piste conductrice 208A. La première piste conductrice 208A peut être reliée à tous les premiers photodétecteurs d'une même colonne. La première piste conductrice 208A est, de préférence, reliée à tous les premiers photodétecteurs du capteur d'images 1.

De la même façon, chaque borne 206B est reliée à une deuxième piste conductrice 208B. La deuxième piste conductrice 208B peut être reliée à tous les deuxièmes photodétecteurs d'une même colonne. La deuxième piste conductrice 208B est, de préférence, reliée à tous les deuxièmes photodétecteurs du capteur d'images 1. La deuxième piste conductrice 208B est, de préférence, distincte de la première piste conductrice 208A.

Dans l'exemple de la figure 3, la première piste conductrice 208A est reliée à une première source de courant 209A qui ne fait pas partie des circuits de lecture 20, 22 des pixels 10, 12 du capteur d'images 1. De même, la deuxième piste conductrice 208B est reliée à une deuxième source de courant 209B qui ne fait pas partie des circuits de lecture 20, 22 des pixels 10, 12 du capteur d'images 1. En d'autres termes, les sources de courant 209A et 209B du capteur d'images 1 sont externes aux pixels et circuits de lecture.

La grille du transistor 202 est destinée à recevoir un signal, noté SEL_R1, de sélection du pixel 10 dans le cas du circuit de lecture 20 du pixel 10. La grille du transistor 202 est destinée à recevoir un autre signal, noté SEL_R2, de sélection du pixel 12 dans le cas du circuit de lecture 22 du pixel 12.

Dans l'exemple de la figure 3 :

la grille du transistor 200 associé au premier photodétecteur 10A du pixel 10 est reliée à un nœud FD_1A ;

la grille du transistor 200 associé au deuxième photodétecteur 10B du pixel 10 est reliée à un nœud FD_1B ;

la grille du transistor 200 associé au premier photodétecteur 12A du pixel 12 est reliée à un nœud FD_2A ; et

la grille du transistor 200 associé au deuxième photodétecteur 12B du pixel 12 est reliée à un nœud FD_2B.

Chaque nœud FD_1A, FD_1B, FD_2A, FD_2B est relié, par un transistor MOS 210 de réinitialisation, à une borne d'application d'un potentiel Vrst de réinitialisation, ce potentiel pouvant être identique au potentiel Vpix. La grille du transistor 210 est destinée à recevoir un signal RST de commande de réinitialisation du photodétecteur, permettant notamment de réinitialiser le nœud FD_1A, FD_1B, FD_2A ou FD_2B sensiblement au potentiel Vrst.

Dans l'exemple de la figure 3 :

le nœud FD_1A est connecté à l'électrode de cathode 102A du premier photodétecteur 10A du pixel 10 ;

le nœud FD_1B est connecté à l'électrode de cathode 102B du deuxième photodétecteur 10B du pixel 10 ;

le nœud FD_2A est connecté à l'électrode de cathode 122A du premier photodétecteur 12A du pixel 12 ; et

le nœud FD_2B est connecté à l'électrode de cathode 122B du deuxième photodétecteur 12B du pixel 12.

Toujours dans l'exemple de la figure 3 :

l'électrode d'anode 104A du premier photodétecteur 10A du pixel 10 est reliée à une source d'un potentiel de référence Vtop_C1 ;

l'électrode d'anode 104B du deuxième photodétecteur 10B du pixel 10 est reliée à une source d'un potentiel de référence Vtop_C2 ;

l'électrode d'anode 124A du premier photodétecteur 12A du pixel 12 est reliée à une source du potentiel de référence Vtop_C1 ; et

l'électrode d'anode 124B du deuxième photodétecteur 12B du pixel 12 est reliée à une source du potentiel de référence Vtop_C2.

Dans le capteur d'images 1, le potentiel Vtop_C1 est appliqué sur la première électrode supérieure commune à tous les premiers photodétecteurs. Le potentiel Vtop_C2 est, quant à lui, appliqué sur la deuxième électrode supérieure commune à tous les deuxièmes photodétecteurs.

Dans la suite de la description, on note arbitrairement :

VFD_1A la tension présente au nœud FD_1A ;

VFD_1B la tension présente au nœud FD_1B ;

VSEL_R1 la tension appliquée sur la grille des transistors 202 du pixel 10, c'est-à-dire la tension appliquée sur la grille du transistor 202 du premier photodétecteur 10A et la tension appliquée sur la grille du transistor 202 du deuxième photodétecteur 10B ; et

VSEL_R2 la tension appliquée sur la grille des transistors 202 du pixel 12, c'est-à-dire la tension appliquée sur la grille du transistor 202 du premier photodétecteur 12A et la tension appliquée sur la grille du transistor 202 du deuxième photodétecteur 12B.

On considère dans la suite de la description que l'application de la tension VSEL_R1, respectivement VSEL_R2, est commandée par le signal binaire noté SEL_R1, respectivement SEL_R2.

On connaît d'autres types de capteurs, par exemple des capteurs dits « 4T ». L'utilisation de photodétecteurs organiques permet avantageusement d'économiser un transistor et d'utiliser un capteur 3T.

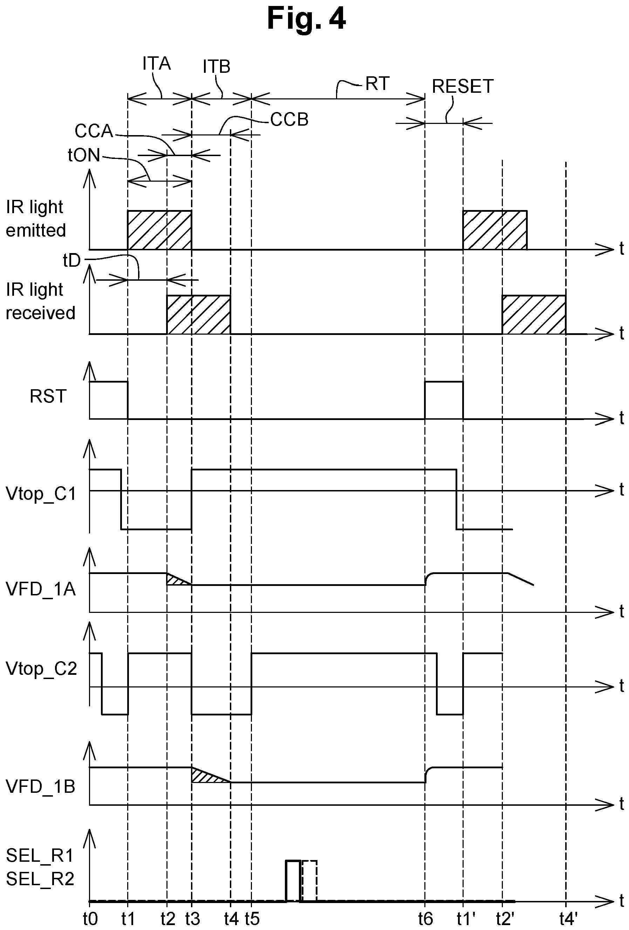

La figure 4 est un chronogramme de signaux d'un exemple de fonctionnement du capteur d'images 1 ayant les circuits de lecture de la figure 3.

Le chronogramme de la figure 4 correspond, plus particulièrement, à un exemple de fonctionnement du capteur d'images 1 en mode « temps de vol » (Time of Flight - ToF). Dans ce mode de fonctionnement, les pixels du capteur d'images 1 sont utilisés pour évaluer une distance les séparant d'un sujet (objet, scène, visage, etc.) placé ou situé en vis-à-vis de ce capteur d'images 1. Pour évaluer cette distance, on commence par émettre une impulsion lumineuse en direction du sujet avec un système émetteur associé non décrit dans ce texte. Cette impulsion lumineuse est généralement obtenue en illuminant brièvement le sujet par un rayonnement provenant d'une source, par exemple un rayonnement infrarouge proche issu d'une diode électroluminescente. Cette impulsion lumineuse est ensuite au moins partiellement réfléchie par le sujet, puis captée par le capteur d'images 1. On calcule ou on mesure alors une durée mise par l'impulsion lumineuse pour parcourir un aller-retour entre la source et le sujet. Le capteur d'images 1 étant avantageusement situé à proximité de la source, cette durée correspond environ au double de la durée mise par l'impulsion lumineuse pour parcourir la distance séparant le sujet de ce capteur d'images 1.

Le chronogramme de la figure 4 illustre un exemple d'évolution des signaux binaires RST et SEL_R1 ainsi que des potentiels Vtop_C1, Vtop_C2, VFD_1A et VFD_1B de deux photodétecteurs d'un même pixel du capteur d'images 1, par exemple le premier photodétecteur 10A et le deuxième photodétecteur 10B du pixel 10. La figure 4 représente aussi, en trait pointillé, le signal binaire SEL_R2 d'un autre pixel du capteur d'images 1, par exemple le pixel 12. Le chronogramme de la figure 4 a été établi en considérant que les transistors MOS du circuit de lecture 20 du pixel 10 sont des transistors à canal N.

À un instant t0, le signal SEL_R1 est à l'état bas de sorte que les transistors 202 du pixel 10 soient bloqués. On entame alors une phase de réinitialisation. Dans ce but, le signal RST est maintenu à l'état haut de sorte que les transistors de réinitialisation 210 du pixel 10 soient passants. Les charges accumulées dans les photodiodes 10A et 10B sont alors évacuées vers la source du potentiel Vrst.

Le potentiel Vtop_C1 est, toujours à l'instant t0, à un niveau haut. Ce niveau haut correspond à une polarisation du premier photodétecteur 10A sous une tension supérieure à une tension résultant de l'application d'un potentiel appelé « potentiel intrinsèque » (built-in potential). Ce potentiel intrinsèque équivaut à une différence entre un travail de sortie de l'anode et un travail de sortie de la cathode. Lorsque le potentiel Vtop_C1 est au niveau haut, le premier photodétecteur 10A n'intègre pas de charges.

Avant un instant t1, postérieur à l'instant t0, le potentiel Vtop_C1 est mis à un niveau bas. Ce niveau bas correspond à une polarisation du premier photodétecteur 10A sous une tension négative, c'est-à-dire inférieure à 0 V. Cela permet ainsi au premier photodétecteur 10A d'intégrer des charges photogénérées. Ce qui a été décrit précédemment en relation avec la polarisation du premier photodétecteur 10A par le potentiel Vtop_C1 se transpose à l'explication du fonctionnement de la polarisation du deuxième photodétecteur 10B par le potentiel Vtop_C2.

À l'instant t1, on commence à émettre une première impulsion lumineuse infrarouge (IR light emitted) vers une scène comprenant un ou des objets dont on souhaite mesurer l'éloignement, ce qui permet d'acquérir une carte de profondeur de la scène. Cette première impulsion lumineuse infrarouge est d'une durée notée tON. À cet instant t1, le signal RST est mis à l'état bas, de sorte que les transistors de réinitialisation 210 du pixel 10 soient bloqués, et le potentiel Vtop_C2 est mis à un niveau haut.

Le potentiel Vtop_C1 étant au niveau bas, on entame ainsi, à l'instant t1, une première phase d'intégration, notée ITA, dans le premier photodétecteur 10A du pixel 10 du capteur d'images 1. On désigne par phase d'intégration d'un pixel la phase pendant laquelle le pixel collecte des charges sous l'effet d'un rayonnement incident.

À un instant t2, postérieur à l'instant t1 et séparé de cet instant t1 par une durée notée tD, on commence à recevoir une deuxième impulsion lumineuse infrarouge (IR light received) issue de la réflexion de la première impulsion lumineuse infrarouge par un objet de la scène, ou par un point d'un objet, dont on souhaite mesurer l'éloignement par rapport au pixel 10. La durée tD est donc fonction de la distance de l'objet au capteur 1. On entame alors une première phase de collection de charges, notée CCA, dans le premier photodétecteur 10A. Cette première phase de collection de charges correspond à une période pendant laquelle des charges sont générées proportionnellement à l'intensité de la lumière incidente, c'est-à-dire proportionnellement à l'intensité lumineuse de la deuxième impulsion, dans le photodétecteur 10A. La première phase de collection de charges provoque une baisse du niveau du potentiel VFD_1A au nœud FD_1A du circuit de lecture 20A.

À un instant t3, dans cet exemple postérieur à l'instant t2 et séparé de l'instant t1 par la durée tON, la première impulsion de lumière infrarouge cesse d'être émise. Le potentiel Vtop_C1 est simultanément mis au niveau haut, marquant ainsi la fin de la première phase d'intégration, donc de la première phase de collection de charges.

Dans un même temps, le potentiel Vtop_C2 est mis à un niveau bas. On entame ainsi, à l'instant t3, une deuxième phase d'intégration, notée ITB, dans le deuxième photodétecteur 10B du pixel 10 du capteur d'images 1. Étant donné que le deuxième photodétecteur 10B reçoit de la lumière issue de la deuxième impulsion lumineuse, on débute, toujours à l'instant t3, une deuxième phase de collection de charges, notée CCB. La deuxième phase de collection de charges provoque une baisse du niveau du potentiel VFD_1B au nœud FD_1B du circuit de lecture 20B.

À un instant t4, postérieur à l'instant t3 et séparé de l'instant t2 par une durée sensiblement égale à tON, la deuxième impulsion lumineuse cesse d'être captée par le deuxième photodétecteur 10B du pixel 10. La deuxième phase de collection de charges s'achève donc à cet instant t4.

À un instant t5, postérieur à l'instant t4, le potentiel Vtop_C2 est mis au niveau haut. Cela marque ainsi la fin de la deuxième phase d'intégration.

Entre l'instant t5 et un instant t6, postérieur à l'instant t5, on effectue une phase de lecture, notée RT, pendant laquelle une mesure de la quantité de charges collectée par les photodiodes des pixels du capteur d'images 1 est réalisée. Pour ce faire, on vient par exemple lire de façon séquentielle les lignes de pixels du capteur d'images 1. Dans l'exemple de la figure 4, les signaux SEL_R1 et SEL_R2 sont successivement mis à l'état haut pour venir lire alternativement les pixels 10 et 12 du capteur d'images 1.

Depuis l'instant t6 et jusqu'à un instant t1', postérieur à l'instant t6, on entame une nouvelle phase de réinitialisation (RESET). Le signal RST est mis à l'état haut de sorte que les transistors de réinitialisation 210 du pixel 10 soient passants. Les charges accumulées dans les photodiodes 10A et 10B sont alors évacuées vers la source du potentiel Vrst.

On calcule la durée tD, qui sépare le début de la première impulsion lumineuse émise du début de la deuxième impulsion lumineuse reçue, à l'aide de la formule suivante :

[Math 1]

$$tD = \frac{tON \times \Delta VFD\_1B}{\Delta VFD\_1A + \Delta VFD\_1B}$$

Dans la formule ci-dessus, la grandeur notée AVFD_1A correspond à une chute du potentiel VFD_1A durant la phase d'intégration du premier photodétecteur 10A. De façon analogue, la grandeur notée AVFD_1B correspond à une chute du potentiel VFD_1B durant la phase d'intégration du deuxième photodétecteur 10B.

À l'instant t1', on débute une nouvelle évaluation de distance par l'émission d'une deuxième impulsion lumineuse. Cette nouvelle évaluation de distance comporte des instants t2' et t4' semblables aux instants t2 et t4, respectivement.

Le fonctionnement du capteur d'images 1 a été illustré ci-dessus en relation avec un exemple de fonctionnement en mode temps de vol, dans lequel les photodétecteurs d'un même pixel sont pilotés de façon désynchronisée. Un avantage du capteur d'images 1 est qu'il peut également fonctionner dans d'autres modes, notamment des modes dans lesquels les photodétecteurs d'un même pixel sont pilotés de façon synchronisée. Le capteur d'images 1 peut, par exemple, être piloté en mode obturateur global (global shutter), c'est-à-dire que ce capteur d'images 1 peut également mettre en œuvre un procédé d'acquisition d'images dans lequel les débuts et fins des phases d'intégration des pixels sont simultanés.

Un avantage du capteur d'images 1 est donc de pouvoir fonctionner alternativement selon différents modes. Le capteur d'images 1 peut, par exemple, fonctionner alternativement en mode temps de vol et en mode d'imagerie à obturateur global.

Selon un mode de mise en œuvre, les circuits de lecture des photodétecteurs du capteur d'images 1 sont pilotés alternativement dans d'autres modes de fonctionnement, par exemple des modes où le capteur d'images 1 est adapté à fonctionner :

dans une partie du spectre infrarouge ;
en lumière structurée ;
en imagerie à grande gamme dynamique (High Dynamic Range - HDR), en faisant en sorte que, pour chaque pixel, la durée d'intégration de l'un des deux photodétecteurs soit supérieure à celle de l'autre photodétecteur ; et/ou
avec suppression de fond.

Le capteur d'images 1 peut ainsi être utilisé pour effectuer différents types d'images sans perte de résolution, car les différents modes d'imagerie pouvant être mis en œuvre par ce capteur d'images 1 exploitent un même nombre de pixels. L'utilisation du capteur d'images 1, capable d'intégrer plusieurs fonctionnalités dans une même matrice de pixels et de circuits de lecture, permet notamment de répondre aux contraintes actuelles de miniaturisation des dispositifs électroniques, par exemple des contraintes de conception et de fabrication de téléphones intelligents (smartphones).

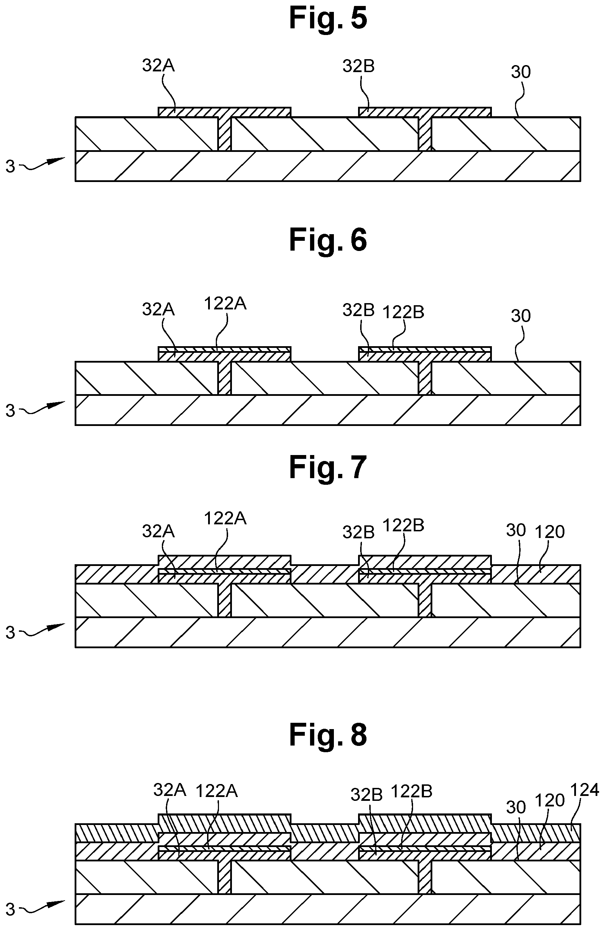

Les figures 5 à 13 ci-dessous illustrent des étapes successives d'un mode de mise en œuvre d'un procédé de réalisation du capteur d'images 1 des figures 1 et 2. Pour simplifier, ce qui est exposé ci-dessous en relation avec les figures 5 à 13 illustre la réalisation d'un seul pixel du capteur d'images 1, par exemple le pixel 12 du capteur d'images 1. Néanmoins, il est entendu que ce procédé peut être étendu à la réalisation d'un nombre quelconque de pixels d'un capteur d'images semblable au capteur d'images 1.

La figure 5 est une vue en coupe, schématique et partielle, d'une étape d'un mode de mise en œuvre d'un procédé de réalisation du capteur d'images 1 des figures 1 et 2.

Selon ce mode de mise en œuvre, on commence par prévoir le support CMOS 3 comportant notamment les circuits de lecture (non représentés) du pixel 12. Ce support CMOS 3 comporte en outre, en surface supérieure 30, des éléments de reprise de contact 32A et 32B. Ces éléments de reprise de contact 32A et 32B présentent, vus en coupe en figure 5, une forme de « T » dont :

une partie horizontale s'étend en surface supérieure 30 du support CMOS 3 ; et
une partie verticale s'étend vers le bas depuis la surface supérieure 30 du support CMOS 3 pour venir contacter des niveaux de métallisation inférieurs (non représentés) du support CMOS 3 reliés ou connectés aux circuits de lecture (non représentés).

Les éléments de reprise de contact 32A et 32B sont par exemple réalisés à partir de pistes conductrices formées en surface supérieure 30 du support CMOS 3 (parties horizontales des éléments de reprise de contact 32A et 32B) et de vias conducteurs (parties verticales des éléments de reprise de contact 32A et 32B) contactant ces pistes conductrices. Les pistes conductrices et les vias conducteurs peuvent être en un matériau métallique, par exemple l'argent (Ag), l'aluminium (Al), l'or (Au), le cuivre (Cu), le nickel (Ni), le titane (Ti) et le chrome (Cr), ou en nitrure de titane (TiN). Les pistes conductrices et les vias conducteurs peuvent avoir une structure monocouche ou multicouche. Dans le cas où les pistes conductrices possèdent une structure multicouche, ces pistes conductrices peuvent être constituées d'un empilement de couches conductrices séparées par des couches isolantes. Les vias traversent alors ces couches isolantes. Les couches conductrices peuvent être en un matériau métallique de la liste ci-dessus et les couches isolantes peuvent être en nitrure de silicium (SiN) ou en oxyde de silicium (SiO$_2$).

Lors de cette même étape, on procède à un nettoyage du support CMOS 3 afin de retirer d'éventuelles impuretés se trouvant à sa surface 30. Ce nettoyage s'effectue, par exemple, par plasma. Le nettoyage permet ainsi d'obtenir une propreté satisfaisante du support CMOS 3 avant d'effectuer une série de dépôts successifs, détaillés en relation avec les figures ci-dessous.

Dans la suite de la description, le mode de mise en œuvre du procédé décrit en relation avec les figures 6 à 13 consiste exclusivement à réaliser des opérations au-dessus de la surface supérieure 30 du support CMOS 3. Le support CMOS 3 des figures 6 à 13 est donc, de préférence, identique au support CMOS 3 tel qu'exposé en relation avec la figure 5 pendant tout le procédé. Pour simplifier, le support CMOS 3 ne sera donc pas à nouveau détaillé dans les figures ci-dessous.

La figure 6 est une vue en coupe, schématique et partielle, d'une autre étape du mode de mise en œuvre du procédé de réalisation du capteur d'images 1 des figures 1 et 2 à partir de la structure telle que décrite en relation avec la figure 5.

Au cours de cette étape, on procède à un dépôt, en surface des éléments de reprise de contact 32A et 32B, d'un matériau injecteur d'électrons. On dépose, de préférence, un matériau s'attachant ou se liant sélectivement en surface des éléments de reprise de contact 32A et 32B pour constituer une monocouche auto-assemblée (Self-Assembled Monolayer - SAM). Ce dépôt recouvre ainsi préférentiellement ou uniquement les surfaces supérieures libres des éléments de reprise de contact 32A et 32B. On forme donc, comme illustré en figure 6 :

l'électrode inférieure 122A du premier photodétecteur organique 12A du pixel 12 ; et
l'électrode inférieure 122B du deuxième photodétecteur organique 12B du pixel 12.

En variante, on procède à un dépôt pleine plaque d'un matériau injecteur d'électrons possédant une conductivité latérale suffisamment faible pour ne pas créer de chemins de conduction entre deux éléments de reprise de contact voisins.

Les électrodes inférieures 122A et 122B constituent des couches d'injection d'électrons (Electron Injection Layer - EIL) des photodétecteurs 12A et 12B, respectivement. Ces électrodes inférieures 122A et 122B sont également appelées cathodes des photodétecteurs 12A et 12B. Les électrodes inférieures 122A et 122B sont, de préférence, réalisées par enduction centrifuge à la tournette (spin coating) ou par enduction par trempage (dip coating).

Le matériau composant les électrodes inférieures 122A et 122B est choisi parmi le groupe comprenant :

un métal ou un alliage métallique, par exemple de l'argent (Ag), de l'aluminium (Al), du plomb (Pb), du palladium (Pd), de l'or (Au), du cuivre (Cu), du nickel (Ni), du tungstène (W), du molybdène (Mo), du titane (Ti) ou du chrome (Cr) ou un alliage de magnésium et d'argent (MgAg) ;
un oxyde conducteur transparent (Transparent Conductive Oxide - TCO), notamment de l'oxyde d'indium dopé à l'étain (Indium Tin Oxide - ITO), un oxyde de zinc et d'aluminium (Aluminium Zinc Oxide - AZO), un oxyde de gallium et de zinc (Gallium Zinc Oxide - GZO), un multicouche ITO/Ag/ITO, un multicouche ITO/Mo/ITO, un multicouche AZO/Ag/AZO ou un multicouche ZnO/Ag/ZnO ;
un polymère de polyéthylèneimine (PEI) ou un polymère de polyéthylèneimine éthoxylée (PEIE), propoxylée et/ou butoxylée ;
des nanofils de carbone, d'argent et/ou de cuivre ;
du graphène ; et
un mélange d'au moins deux de ces matériaux.

Les électrodes inférieures 122A et 122B peuvent avoir une structure monocouche ou multicouche.

La figure 7 est une vue en coupe, schématique et partielle, d'encore une autre étape du mode de mise en œuvre du procédé de réalisation du capteur d'images 1 des figures 1 et 2 à partir de la structure telle que décrite en relation avec la figure 6.

Au cours de cette étape, on procède à un dépôt non sélectif d'une première couche 120 du côté de la surface supérieure 30 du support CMOS 3. Ce dépôt est qualifié de dépôt « pleine plaque » car il recouvre la totalité de la surface supérieure 30 du support CMOS 3 ainsi que les surfaces libres des éléments de reprise de contact 32A, 32B et des électrodes inférieures 122A et 122B. Le dépôt de la première couche 120 est, de préférence, réalisé par enduction centrifuge à la tournette.

Selon ce mode de mise en œuvre, la première couche 120 est destinée à former les futures couches actives 120A et 120B des photodétecteurs 12A et 12B du pixel 12. Les couches actives 120A et 120B des photodétecteurs 12A et 12B du pixel 12 possèdent, de préférence, une composition et une épaisseur identiques à celles de la première couche 120.

La première couche 120 peut comprendre des petites molécules, des oligomères ou des polymères. Il peut s'agir de matériaux organiques ou inorganiques, notamment comprenant des boîtes quantiques. La première couche 120 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la première couche 120 peut être comprise entre 50 nm et 2 µm, par exemple de l'ordre de 300 nm.

Des exemples de polymères semiconducteurs de type P adaptés à la réalisation de la couche 120 sont :

le poly(3-hexylthiophène) (P3HT) ;

le poly[N-9'-heptadécanyl-2,7-carbazole-alt-5,5-(4,7-di-2-thiényl-2',1',3'-benzothiadiazole)] (PCDTBT) ;

le poly[(4,8-bis-(2-éthylhexyloxy)-benzo[1,2-b;4,5-b'] dithiophène)-2,6-diyl-alt-(4-(2-éthylhexanoyl)-thieno[3,4-b]thiophène))-2,6-diyl](PBDTTT-C) ;

le poly[2-méthoxy-5-(2-éthyl-hexyloxy)-1,4-phénylène-vinylène] (MEH-PPV) ; et

le poly[2,6-(4,4-bis-(2-éthylhexyl)-4$H$-cyclopenta[2,1-$b$;3,4-$b$']dithiophène)-alt-4,7(2,1,3-benzothiadiazole)] (PCPDTBT) .

Des exemples de matériaux semiconducteurs de type N adaptés à la réalisation de la couche 120 sont les fullerènes, notamment le C60, le [6,6]-phényl-C$_{61}$-butanoate de méthyle ([60]PCBM), le [6,6]-phényl-C$_{71}$-butanoate de méthyle ([70]PCBM), le pérylène diimide, l'oxyde de zinc (ZnO) ou des nanocristaux permettant la formation de boîtes quantiques (quantum dots).

La figure 8 est une vue en coupe, schématique et partielle, d'encore une autre étape du mode de mise en œuvre du procédé de réalisation du capteur d'images 1 des figures 1 et 2 à partir de la structure telle que décrite en relation avec la figure 7.

Au cours de cette étape, on procède à un dépôt non sélectif d'une deuxième couche 124 du côté de la surface supérieure 30 du support CMOS 3. Ce dépôt est qualifié de dépôt « pleine plaque » car il recouvre la totalité de la surface supérieure de la première couche 120. Le dépôt de la deuxième couche 124 est, de préférence, effectué par enduction centrifuge à la tournette.

Selon ce mode de mise en œuvre, la deuxième couche 124 est destinée à former les futures électrodes supérieures 124A et 124B des photodétecteurs 12A et 12B du pixel 12. Les électrodes supérieures 124A et 124B des photodétecteurs 12A et 12B du pixel 12 possèdent, de préférence, une composition et une épaisseur identiques à celles de la deuxième couche 124.

La deuxième couche 124 est au moins partiellement transparente au rayonnement lumineux qu'elle reçoit. La deuxième couche 124 peut être en un matériau conducteur et transparent, par exemple en oxyde conducteur et transparent (Transparent Conductive Oxide - TCO), en nanotubes de carbone, en graphène, en un polymère conducteur, en un métal, ou en un mélange ou un alliage d'au moins deux de ces composés. La deuxième couche 124 peut avoir une structure monocouche ou multicouche.

Des exemples de TCO adaptés à la réalisation de la deuxième couche 124 sont l'oxyde d'indium-étain (Indium Tin Oxide - ITO), l'oxyde d'aluminium-zinc (Aluminium Zinc Oxide - AZO), l'oxyde de gallium-zinc (Gallium Zinc Oxide - GZO), le nitrure de titane (TiN), l'oxyde de molybdène (MoO$_3$) et l'oxyde de tungstène (WO$_3$) . Un exemple de polymère conducteur adapté à la réalisation de la deuxième couche 124 est le polymère connu sous la dénomination PEDOT:PSS, qui est un mélange de poly(3,4)-éthylènedioxythiophène et de polystyrène sulfonate de sodium et la polyaniline, également appelé PAni. Des exemples de métaux adaptés à la réalisation de la deuxième couche 124 sont l'argent, l'aluminium, l'or, le cuivre, le nickel, le titane et le chrome. Un exemple de structure multicouche adaptée à la réalisation de la deuxième couche 124 est une structure multicouche d'AZO et d'argent de type AZO/Ag/AZO.

L'épaisseur de la deuxième couche 124 peut être comprise entre 10 nm et 5 $\mu$m, par exemple de l'ordre de 30 nm. Dans le cas où la deuxième couche 124 est métallique, l'épaisseur de cette deuxième couche 124 est inférieure ou égale à 20 nm, de préférence inférieure ou égale à 10 nm.

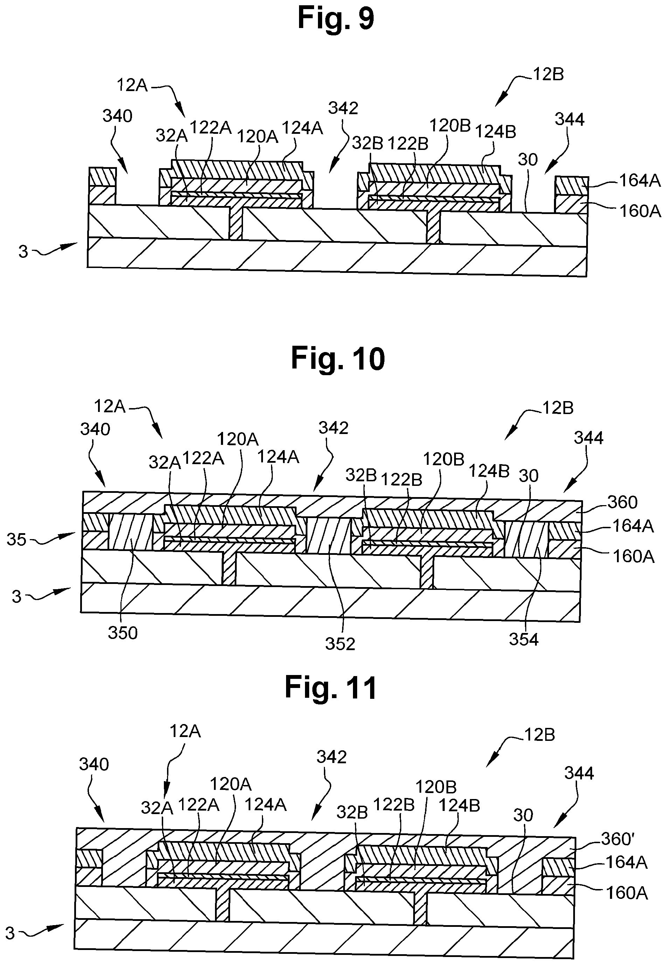

La figure 9 est une vue en coupe, schématique et partielle, d'encore une autre étape du mode de mise en œuvre du procédé de réalisation du capteur d'images des figures 1 et 2 à partir de la structure telle que décrite en relation avec la figure 8.

Au cours de cette étape, on pratique trois ouvertures verticales 340, 342 et 344 à travers la première couche 120 et la deuxième couche 124 jusqu'à la surface supérieure 30 du support CMOS 3. Ces ouvertures sont, de préférence, réalisées par gravure après masquage des zones à protéger, par exemple par dépôt de résine photosensible, exposition à travers un masque puis gravure sèche, par exemple par gravure ionique réactive, ou par gravure humide, par exemple par gravure chimique. En variante, le dépôt du masque de gravure est effectué de façon localisée, par exemple par sérigraphie, par héliographie, par nano-impression (nano imprint) ou par flexographie, et la gravure est réalisée par gravure sèche, par exemple par gravure ionique réactive, ou par gravure humide, par exemple par gravure chimique.

Dans l'exemple de la figure 9 :

les ouvertures verticales 340 et 342 sont situées de part et d'autre du premier élément de reprise de contact 32A (respectivement à gauche et à droite du premier élément de reprise de contact 32A) ; et

les ouvertures verticales 342 et 344 sont situées de part et d'autre du deuxième élément de reprise de contact 32B (respectivement à gauche et à droite du deuxième élément de reprise de contact 32B).

Ces ouvertures verticales 340, 342 et 344 ont pour but de séparer des photodétecteurs appartenant à une même ligne du capteur d'images 1. Les ouvertures 340, 342 et 344 sont, par exemple, réalisées par photolithographie. En variante, les ouvertures 340, 342 et 344 sont réalisées par gravure ionique réactive ou par gravure chimique à l'aide d'un solvant adéquat.

On obtient ainsi, comme illustré en figure 9 :

la couche active 120A du premier photodétecteur 12A du pixel 12, qui recouvre entièrement les faces libres du premier élément de reprise de contact 32A et l'électrode inférieure 122A ;

la couche active 120B du deuxième photodétecteur 12B du pixel 12, qui recouvre entièrement les faces libres du deuxième élément de reprise de contact 32B et l'électrode inférieure 122B ;

l'électrode supérieure 124A du premier photodétecteur 12A du pixel 12, recouvrant la couche active 120A ; et

l'électrode supérieure 124B du deuxième photodétecteur 12B du pixel 12, recouvrant la couche active 120B.

Ainsi, toujours dans l'exemple de la figure 9 :

l'ouverture 340 est intercalée entre, d'une part, la couche active 120A et l'électrode supérieure 124A du premier photodétecteur 12A du pixel 12 et, d'autre part, une couche active et une électrode supérieure d'un deuxième photodétecteur appartenant à un pixel voisin (non représenté) ;

l'ouverture 342 est intercalée entre, d'une part, la couche active 120A et l'électrode supérieure 124A du premier photodétecteur 12A du pixel 12 et, d'autre part, la couche active 120B et l'électrode supérieure 124B du deuxième photodétecteur 12B du pixel 12 ; et

l'ouverture 344 est intercalée entre, d'une part, la couche active 120B et l'électrode supérieure 124B du deuxième photodétecteur 12B du pixel 12 et, d'autre part, la couche active 160A et l'électrode supérieure 164A du premier photodétecteur 16A du pixel 16 (partiellement visible en figure 9).

Les électrodes supérieures 124A et 124B constituent des couches d'injection de trous (Hole Injection Layer - HIL) des photodétecteurs 12A et 12B, respectivement. Ces électrodes supérieures 124A et 124B sont également appelées anodes des photodétecteurs 12A et 12B.

Les électrodes supérieures 124A et 124B sont, de préférence, constituées du même matériau que la couche 124 dans laquelle elles sont formées, comme exposé en relation avec la figure 8.

La figure 10 est une vue en coupe, schématique et partielle, d'encore une autre étape du mode de mise en œuvre du procédé de réalisation du capteur d'images 1 des figures 1 et 2 à partir de la structure telle que décrite en relation avec la figure 9.

Au cours de cette étape, on vient combler les ouvertures 340, 342 et 344 par une troisième couche 35 d'isolation dont seules des parties 350, 352 et 354 sont visibles en figure 10. Les parties 350, 352 et 354 de la troisième couche d'isolation 35 remplissent respectivement les ouvertures 340, 342 et 344.

Les parties 350, 352 et 354 de la troisième couche 35 ont pour but d'isoler électriquement des photodétecteurs voisins appartenant à une même ligne du capteur d'images 1. Selon un mode de mise en œuvre, les parties 350, 352 et 354 de la troisième couche 35 absorbent au moins partiellement la lumière reçue par le capteur d'images 1 afin d'isoler optiquement les photodétecteurs d'une même ligne. La troisième couche d'isolation peut être réalisée à partir d'une résine dont l'absorption couvre au moins les longueurs d'onde des photodiodes (visible et infrarouge). Une telle résine, d'un aspect noir, est alors qualifiée de « résine noire » (black resin). Dans l'exemple de la figure 10, la partie 352 isole électriquement et optiquement le premier photodétecteur 12A du deuxième photodétecteur 12B du pixel 12.

La troisième couche isolante 35 peut être en un matériau inorganique, par exemple en oxyde de silicium ($SiO_2$) ou en nitrure de silicium (SiN). Dans le cas où la troisième couche isolante 35 est en nitrure de silicium, ce matériau est, de préférence, obtenu par dépôt physique par phase vapeur (Physical Vapor Deposition - PVD) ou par dépôt chimique en phase vapeur assisté par plasma (Plasma-Enhanced Chemical Vapor Deposition - PECVD).

La troisième couche isolante 35 peut être réalisée en polymère fluoré, notamment le polymère fluoré connu sous la dénomination commerciale « Cytop » de la société Bellex, en polyvinylpyrrolidone (PVP), en polyméthacrylate de méthyle (PMMA), en polystyrène (PS), en parylène, en polyimide (PI), en acrylonitrile butadiène styrène (ABS), en polydiméthylsiloxane (PDMS), en une résine de photolithographie, en résine époxy, en résine acrylate ou en un mélange d'au moins deux de ces composés.

A titre de variante, la troisième couche isolante 35 peut être réalisée en un autre diélectrique inorganique, notamment en oxyde d'aluminium ($Al_2O_3$). L'oxyde d'aluminium peut être déposé par dépôt de couches minces atomiques (Atomic Layer Deposition - ALD). L'épaisseur maximale de la troisième couche isolante 35 peut être comprise entre 50 nm et 2 $\mu$m, par exemple de l'ordre de 100 nm.

Une quatrième couche 360 est ensuite déposée sur toute la structure du côté de la surface supérieure 30 du support CMOS 3. Cette quatrième couche 360 est, de préférence, une couche dite de « planarisation » permettant d'obtenir une structure présentant une surface supérieure plane avant encapsulation des photodétecteurs.

La quatrième couche 360 de planarisation peut être constituée d'un matériau diélectrique à base de polymères. La couche 360 de planarisation peut alternativement contenir un mélange de nitrure de silicium (SiN) et d'oxyde de silicium ($SiO_2$), ce mélange étant obtenu par pulvérisation (sputtering), par dépôt physique par phase vapeur (Physical Vapor Deposition - PVD) ou par dépôt chimique en phase vapeur assisté par plasma (Plasma-Enhanced Chemical Vapor Deposition - PECVD).

La couche 360 de planarisation peut également être réalisée en polymère fluoré, notamment le polymère fluoré connu sous la dénomination commerciale « Cytop » de la société Bellex, en polyvinylpyrrolidone (PVP), en polyméthacrylate de méthyle (PMMA), en polystyrène (PS), en parylène, en polyimide (PI), en acrylonitrile butadiène styrène (ABS), en polydiméthylsiloxane (PDMS), en une résine de photolithographie, en résine époxy, en résine acrylate ou en un mélange d'au moins deux de ces composés.

La figure 11 est une vue en coupe, schématique et partielle, d'une variante du mode de mise en œuvre du procédé de réalisation du capteur d'images 1 des figures 1 et 2 à partir de la structure telle que décrite en relation avec la figure 9.

Cette variante diffère de l'étape exposée en relation avec la figure 10 principalement en ce que les ouvertures 340, 342 et 344 ne sont ici pas respectivement remplies (ou comblées) par les parties 350, 352 et 354 de la troisième couche d'isolation 35 mais par une couche 360' constituée, de préférence, d'un matériau identique à celui de la quatrième couche 360. En d'autres termes, la variante illustrée en figure 11 revient à ne pas réaliser le dépôt de la troisième couche d'isolation 35 et à procéder directement au dépôt de la quatrième couche 360 pour former la cinquième couche 360'. Le cas échéant, seuls les matériaux transparents listés pour la quatrième couche 360 comme exposé en relation avec la figure 10 sont adaptés à former la cinquième couche 360'. En particulier, la cinquième couche 360' n'est pas constituée de résine noire.

On suppose, dans la suite de la description, que la variante exposée en relation avec la figure 11 n'est pas retenue dans le mode de mise en œuvre du procédé. Toutefois, l'adaptation des étapes qui suivent à un cas où la cinquième couche 360' est réalisée en lieu et place des parties 350, 352, 354 de la troisième couche 35 et de la quatrième couche 360 est à la portée de l'homme du métier à partir des indications fournies ci-dessous.

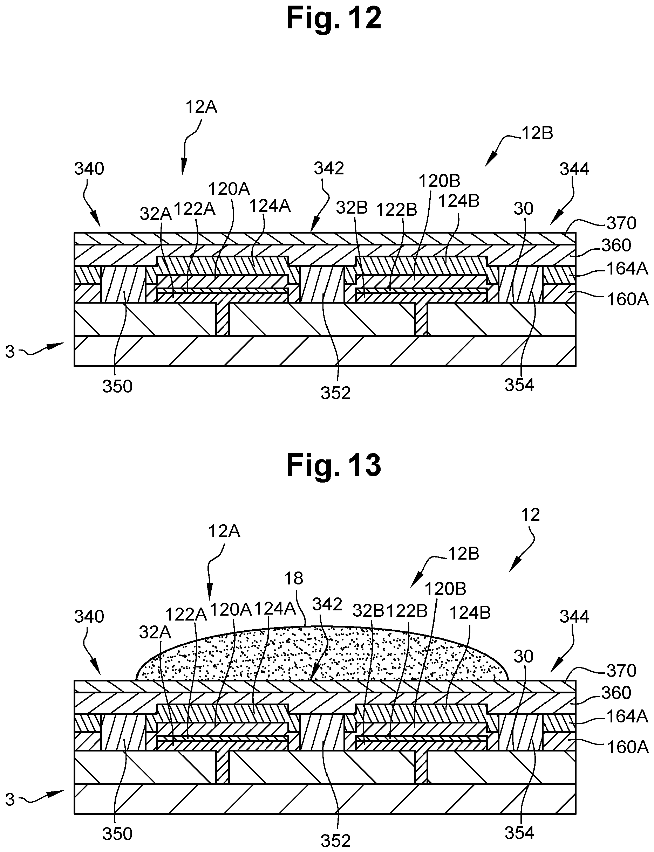

La figure 12 est une vue en coupe, schématique et partielle, d'encore une autre étape du mode de mise en œuvre du procédé de réalisation du capteur d'images 1 des figures 1 et 2 à partir de la structure telle que décrite en relation avec la figure 10.

Au cours de cette étape, on dépose une sixième couche 370 sur toute la structure du côté de la surface supérieure 30 du support CMOS 3. Cette sixième couche 370 a pour but d'encapsuler les photodétecteurs organiques du capteur d'images 1. La sixième couche 370 permet ainsi d'éviter la dégradation, du fait d'une exposition à l'eau ou à l'humidité contenue dans l'air ambiant, des matériaux organiques constitutifs des photodétecteurs du capteur d'images 1. Dans l'exemple de la figure 12, la sixième couche 370 recouvre la totalité de la surface supérieure libre de la quatrième couche de planarisation 360.

La sixième couche 370 peut être constituée d'alumine ($Al_2O_3$) obtenue par un procédé de dépôt par couches minces atomiques (Atomic Layer Deposition - ALD), de nitrure de silicium ($Si_3N_4$) ou d'oxyde de silicium ($SiO_2$) obtenus par dépôt physique par phase vapeur (PVD), de nitrure de silicium obtenu par dépôt chimique en phase vapeur assisté par plasma (PECVD). La sixième couche 370 peut alternativement être constituée de PET, de PEN, de COP ou de CPI.

Selon un mode de mise en œuvre, la sixième couche 370 permet d'améliorer encore davantage l'état de surface de la structure avant réalisation des microlentilles.

La figure 13 est une vue en coupe, schématique et partielle, d'encore une autre étape du mode de mise en œuvre du procédé de réalisation du capteur d'images 1 des figures 1 et 2 à partir de la structure telle que décrite en relation avec la figure 12.

Au cours de cette étape, on vient réaliser la microlentille 18 du pixel 12 à l'aplomb des photodétecteurs 12A et 12B. Dans l'exemple de la figure 13, cette microlentille 18 est sensiblement centrée par rapport à l'ouverture 342 séparant les deux photodétecteurs 12A, 12B. En d'autres termes, la microlentille 18 est approximativement alignée par rapport à la partie 352 de la troisième couche d'isolation 35 (figure 10). On obtient ainsi le pixel 12 du capteur d'images 1.

Selon les matériaux considérés, le procédé de formation des couches du capteur d'images 1 peut correspondre à un procédé dit additif, par exemple par impression directe du matériau composant les couches organiques aux emplacements souhaités notamment sous forme de sol-gel, par exemple par impression par jet d'encre, héliographie, sérigraphie, flexographie, revêtement par pulvérisation (spray coating) ou dépôt de gouttes (drop-casting). Selon les matériaux considérés, le procédé de formation des couches du capteur d'images peut correspondre à un procédé dit soustractif, dans lequel le matériau composant les couches organiques est déposé sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par enduction fente (slot-die coating), revêtement à la lame (blade-coating), flexographie ou sérigraphie. Lorsque les couches sont métalliques, le métal est, par exemple, déposé par évaporation ou par pulvérisation cathodique sur l'ensemble du support et les couches métalliques sont délimitées par gravure.

De façon avantageuse, au moins certaines des couches du capteur d'images peuvent être réalisées par des techniques d'impression. Les matériaux de ces couches décrites précédemment peuvent être déposés sous forme liquide, par exemple sous forme d'encres conductrices et semiconductrices à l'aide d'imprimantes à jet d'encre. Par matériaux sous forme liquide, on entend ici également des matériaux en gel déposables par des techniques d'impression. Des étapes de recuit sont éventuellement prévues entre les dépôts des différentes couches, mais les températures de recuit peuvent ne pas dépasser 150 °C, et le dépôt et les éventuels recuits peuvent être réalisés à la pression atmosphérique.

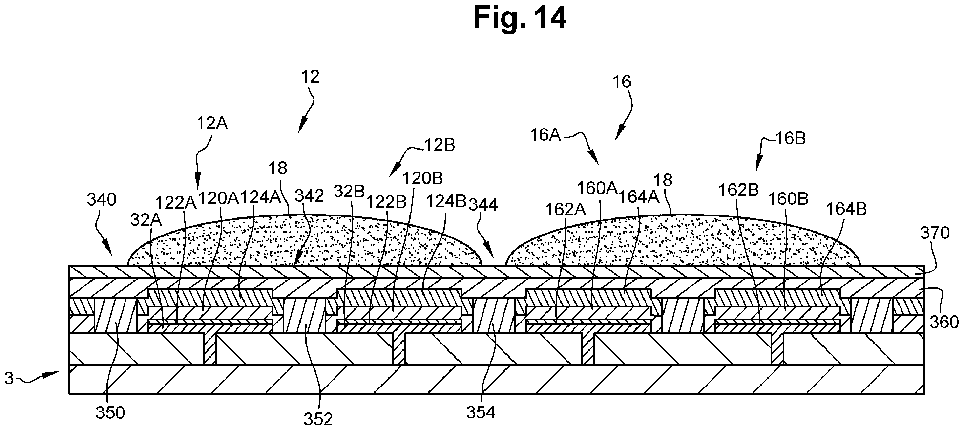

La figure 14 est une vue en coupe selon le plan AA (figure 2), schématique et partielle, du capteur d'images 1 des figures 1 et 2. Le plan de coupe AA correspond à un plan de coupe parallèle à une ligne de pixels du capteur d'images 1.

En figure 14, seuls les pixels 12 et 16 du capteur d'images 1 ont été représentés. Ces pixels 12 et 16 appartiennent à une même ligne de pixels du capteur d'images 1. Dans l'exemple de la figure 14, les photodétecteurs 12A, 12B du pixel 12 et les photodétecteurs 16A, 16B du pixel 16 sont séparés les uns des autres. Ainsi, le long d'une même ligne du capteur d'images 1, chaque photodétecteur est isolé des photodétecteurs voisins.

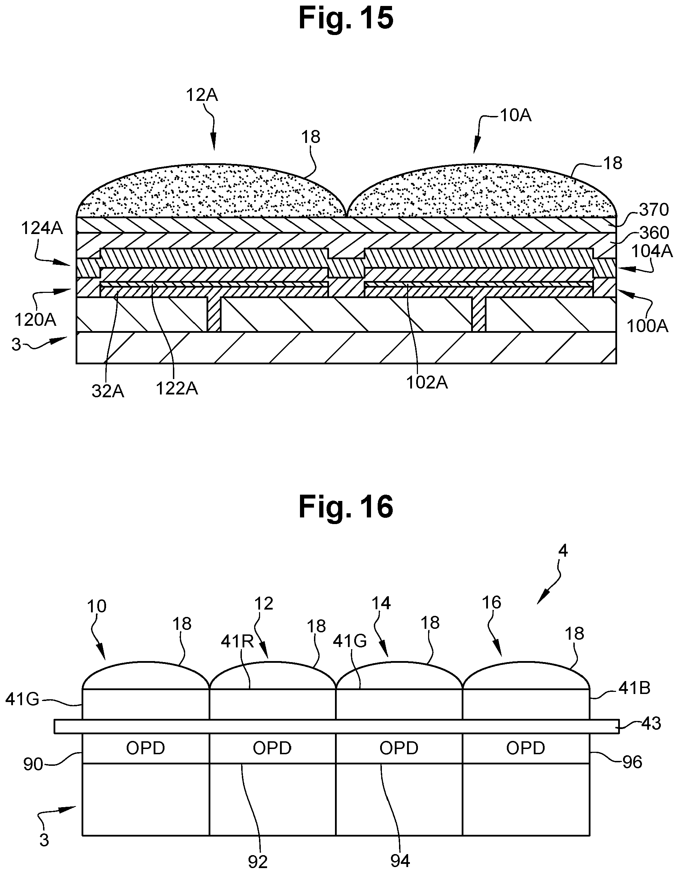

La figure 15 est une vue en coupe selon le plan BB (figure 2), schématique et partielle, du capteur d'images 1 des figures 1 et 2. Le plan de coupe BB correspond à un plan de coupe parallèle à une colonne de pixels du capteur d'images 1.

En figure 15, seuls les premiers photodétecteurs 10A et 12A des pixels 10 et 12, respectivement, sont visibles. Dans l'exemple de la figure 15 :

l'électrode inférieure 102A du premier photodétecteur 10A du pixel 10 est séparée de l'électrode inférieure 122A du premier photodétecteur 12A du pixel 12 ;
la couche active 100A du premier photodétecteur 10A du pixel 10 et la couche active 120A du premier photodétecteur 12A du pixel 12 sont formées par un même dépôt continu ; et
l'électrode supérieure 104A du premier photodétecteur 10A du pixel 10 et l'électrode supérieure 124A du premier photodétecteur 12A du pixel 12 sont formées par un même autre dépôt continu.

En d'autres termes, tous les premiers photodétecteurs des pixels appartenant à une même colonne de pixels du capteur d'images 1 possèdent une couche active commune et une électrode supérieure commune. L'électrode supérieure permet ainsi d'adresser tous les premiers photodétecteurs des pixels d'une même colonne tandis que l'électrode inférieure permet d'adresser chaque premier photodétecteur de façon individuelle.

De même, tous les deuxièmes photodétecteurs des pixels appartenant à une même colonne de pixels du capteur d'images 1 possèdent une autre couche active commune, distincte de la couche active commune des premiers photodétecteurs de ces mêmes pixels, et une autre électrode supérieure commune, distincte de l'électrode supérieure commune des premiers photodétecteurs de ces mêmes pixels. Cette autre électrode supérieure commune permet ainsi d'adresser tous les deuxièmes photodétecteurs des pixels d'une même colonne tandis que l'électrode inférieure permet d'adresser chaque deuxième photodétecteur de façon individuelle.

La figure 16 est une vue en coupe, schématique et partielle, d'un autre mode de réalisation d'un capteur d'images 4.

Le capteur d'images 4 représenté en figure 16 est analogue au capteur d'images 1 exposé en relation avec les figures 1 et 2. Ce capteur d'images 4 diffère du capteur d'images 1 principalement en ce que :

les pixels 10, 12, 14 et 16 du capteur d'images 4 appartiennent à une même ligne ou à une même colonne de ce capteur d'images 4 (tandis que les pixels 10, 12, 14 et 16 du capteur d'images 1 (figure 1) sont répartis sur deux lignes et deux colonnes différentes de ce capteur d'images 1) ; et
chaque pixel 10, 12, 14 et 16 du capteur d'images 4 possède un filtre couleur 41R, 41G ou 41B sous sa microlentille 18 et sur une couche de passivation 43. En d'autres termes, les quatre pixels monochromatiques 10, 12, 14 et 16 disposés en carré en figure 1 sont ici mis côte à côte en figure 16.

Plus précisément, dans l'exemple de la figure 16, le capteur d'images 4 comporte :

un premier filtre vert 41G, intercalé entre la microlentille 18 du pixel 10 et la couche de passivation 43 ;
un filtre rouge 41R, intercalé entre la microlentille 18 du pixel 12 et la couche de passivation 43 ;
un deuxième filtre vert 41G, intercalé entre la microlentille 18 du pixel 14 et la couche de passivation 43 ; et
un filtre bleu 41B, intercalé entre la microlentille 18 du pixel 16 et la couche de passivation 43.

Selon ce mode de réalisation, les filtres couleur 41R, 41G et 41B du capteur d'images 4 laissent passer les ondes électromagnétiques dans des plages de fréquences différentes du spectre visible et laissent passer les ondes électromagnétiques du spectre infrarouge. Les filtres couleur 41R, 41G et 41B peuvent correspondre à des blocs de résine colorée. Chaque filtre couleur 41R, 41G et 41B est adapté à laisser passer le rayonnement infrarouge, par exemple à une longueur d'onde comprise entre 700 nm et 1 mm, et, pour au moins certains des filtres couleur, à laisser passer une plage de longueurs d'onde de la lumière visible.

Pour chaque pixel d'une image couleur à acquérir, le capteur d'images 4 peut comprendre :

au moins un pixel (par exemple, le pixel 16) dont le filtre couleur 41B est adapté à laisser passer le rayonnement infrarouge et la lumière bleue, par exemple dans la plage de longueurs d'onde de 430 nm à 490 nm ;
au moins un pixel (par exemple, les pixels 10 et 14) dont le filtre couleur 41G est adapté à laisser passer le rayonnement infrarouge et la lumière verte, par exemple dans la plage de longueurs d'onde de 510 nm à 570 nm ; et

au moins un pixel (par exemple, le pixel 12) dont le filtre couleur 41R est adapté à laisser passer le rayonnement infrarouge et la lumière rouge, par exemple dans la plage de longueurs d'onde de 600 nm à 720 nm.

De façon analogue au capteur d'images 1 exposé en relation avec les figures 1 et 2, chaque pixel 10, 12, 14, 16 du capteur d'images 4 dispose d'un premier et d'un deuxième photodétecteur. Chaque pixel comporte ainsi deux photodétecteurs, représentés de façon très schématique en figure 16 par un même bloc (OPD). Plus précisément, en figure 16 :

le pixel 10 comporte deux photodétecteurs organiques (bloc 90, OPD) ;
le pixel 12 comporte deux photodétecteurs organiques (bloc 92, OPD) ;
le pixel 14 comporte deux photodétecteurs organiques (bloc 94, OPD) ; et
le pixel 16 comporte deux photodétecteurs organiques (bloc 96, OPD).

Les photodétecteurs de chaque pixel 10, 12, 14 et 16 sont coplanaires et associés chacun à un circuit de lecture comme exposé en relation avec la figure 3. Ces circuits de lecture sont réalisés sur et à l'intérieur du support CMOS 3. Le capteur d'images 4 est ainsi capable, par exemple, de réaliser alternativement des estimations de distance par temps de vol dans l'infrarouge et des captures d'images en couleur.

Divers modes de réalisation, modes de mise en œuvre et variantes ont été décrits. L'homme de l'art comprendra que certaines caractéristiques de ces divers modes de réalisation, modes de mise en œuvre et variantes pourraient être combinées, et d'autres variantes apparaîtront à l'homme de l'art.

Enfin, la mise en œuvre pratique des modes de réalisation, modes de mise en œuvre et variantes décrits est à la portée de l'homme du métier à partir des indications fonctionnelles données ci-dessus. En particulier, l'adaptation du pilotage des circuits de lecture des capteurs d'images 1 et 4 à d'autres modes de fonctionnement, par exemple pour la réalisation d'images infrarouges avec ou sans lumière ajoutée, la réalisation d'images avec suppression de fond et la réalisation d'images à grande gamme dynamique (HDR simultané) est à la portée de l'homme du métier à partir des indications ci-dessus.

## Revendications

**1.** Capteur d'images (1 ; 4) comportant plusieurs pixels (10, 12, 14, 16), chaque pixel comprenant :

un support CMOS (3) ;

exactement un premier photodétecteur organique (10A, 12A, 14A, 16A) et un deuxième photodétecteur organique (10B, 12B, 14B, 16B), chaque photodétecteur organique comportant une première électrode (102A, 102B, 122A, 122B, 142A, 142B, 162A, 162B), distincte de premières électrodes des autres photodétecteurs organiques, formée en surface (30) du support CMOS ; et

une même lentille (18) à l'aplomb des premier et deuxième photodétecteurs organiques, dans lequel chaque premier photodétecteur organique est connecté à une deuxième électrode (104A, 124A, 144A, 164A) commune à tous les premiers photodétecteurs organiques des pixels du capteur et chaque deuxième photodétecteur organique est connecté à une troisième électrode (104B, 124B, 144B, 164B) commune à tous les deuxièmes photodétecteurs organiques des pixels du capteur.

**2.** Procédé de fabrication d'un capteur d'images selon la revendication 1, comprenant des étapes consistant à :

prévoir le support CMOS (3) ;
réaliser les premier (10A, 12A, 14A, 16A) et deuxième (10B, 12B, 14B, 16B) photodétecteurs organiques de chaque pixel ; et
réaliser la lentille (18) à l'aplomb des premier et deuxième photodétecteurs organiques de chaque pixel.

**3.** Capteur selon la revendication 1 ou procédé selon la revendication 2, dans lequel les premier (10A, 12A, 14A, 16A) et deuxième (10B, 12B, 14B, 16B) photodétecteurs organiques sont coplanaires.

**4.** Capteur selon la revendication 1 ou 3, ou procédé selon la revendication 2 ou 3, dans lequel les premier (10A, 12A, 14A, 16A) et deuxième (10B, 12B, 14B, 16B) photodétecteurs organiques sont séparés les uns des autres par un diélectrique (35, 350, 352, 354 ; 360').

**5.** Capteur selon la revendication 1, 3 ou 4, ou procédé selon l'une quelconque des revendications 2 à 4, dans lequel chaque première électrode (102A, 102B, 122A, 122B, 142A, 142B, 162A, 162B) est reliée, de préférence connectée, à un circuit de lecture (20A, 20B, 22A, 22B), chaque circuit de lecture comportant, de préférence, trois transistors (200, 202, 210) formés dans le support CMOS (3).

**6.** Capteur selon l'une quelconque des revendications 1, 3 à 5, ou procédé selon l'une quelconque des revendications 2 à 5, dans lequel les premier (10A, 12A, 14A, 16A) et deuxième (10B, 12B, 14B, 16B) photodétecteurs organiques sont adaptés à évaluer une distance par temps de vol.

7. Capteur selon l'une quelconque des revendications 1, 3 à 6, adapté à fonctionner :

> dans une partie du spectre infrarouge ;
> en lumière structurée ;
> en imagerie à grande gamme dynamique, HDR ; et/ou avec suppression de fond.

8. Capteur selon l'une quelconque des revendications 1, 3 à 7, dans lequel chaque pixel (10, 12, 14, 16) comporte en outre, sous la lentille (18), un filtre couleur (41R, 41G, 41B) laissant passer les ondes électromagnétiques dans une plage de fréquences du spectre visible et dans le spectre infrarouge.

9. Capteur selon la revendication 8, adapté à capter une image couleur.

10. Capteur selon l'une quelconque des revendications 1, 3 à 9, ou procédé selon l'une quelconque des revendications 2 à 6, dans lequel, pour chaque pixel (10, 12, 14, 16), le premier photodétecteur organique (10A, 12A, 14A, 16A) et le deuxième photodétecteur organique (10B, 12B, 14B, 16B) sont de forme rectangulaire et s'inscrivent conjointement dans un carré.

**Fig. 1**

**Fig. 2**

**Fig. 3**

# Fig. 4

# Fig. 5

# Fig. 6

# Fig. 7

# Fig. 8

# Fig. 9

# Fig. 10

# Fig. 11

# Fig. 12

# Fig. 13

# Fig. 14

EP 3 767 677 A1

# Fig. 15

# Fig. 16

Europäisches
Patentamt

European
Patent Office

Office européen
des brevets

**RAPPORT DE RECHERCHE EUROPEENNE**

Numéro de la demande

EP 20 18 6097

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2017/257587 A1 (HATANO KEISUKE [JP] ET AL) 7 septembre 2017 (2017-09-07) | 1-5,8-10 | INV. H01L27/30 H01L51/44 H04N5/369 H01L27/146 |
| Y | * alinéa [0179]; figure 16 * | 6,7 | |
| | * figures 3,18 * | | |
| | * alinéas [0078], [0090], [0091] * | | |
| | ----- | | |
| X,P | EP 3 579 021 A1 (PANASONIC IP MAN CO LTD [JP]) 11 décembre 2019 (2019-12-11) | 1-10 | |
| | * alinéa [0071] - alinéa [0072]; figure 2 * | | |
| | * alinéas [0002], [0073] - alinéa [0080]; figures 3,4 * | | |
| | * alinéas [0115], [0116], [0117]; figures 6,7 * | | |
| | * alinéa [0178]; figure 13 * | | |
| | ----- | | |
| Y | DE 10 2016 102111 A1 (SAMSUNG ELECTRONICS CO LTD [KR]) 18 août 2016 (2016-08-18) | 7 | |
| | * alinéa [0187] - alinéa [0193]; figure 17 * | | DOMAINES TECHNIQUES RECHERCHES (IPC) |
| | * alinéas [0081], [0083], [0087], [0162], [0181], [0197], [0228], [0230] * | | H01L H04N |
| | * figures 4B,14,15A,17 * | | |
| | ----- | | |
| A | US 2013/182173 A1 (MURATA HIRONOBU [JP]) 18 juillet 2013 (2013-07-18) | 1-10 | |
| | * alinéa [0062]; figures 9A,9B * | | |
| | * alinéas [0003], [0043], [0056], [0063] * | | |
| | ----- | | |
| | -/-- | | |

Le présent rapport a été établi pour toutes les revendications

| Lieu de la recherche | Date d'achèvement de la recherche | Examinateur |
|---|---|---|
| Munich | 26 octobre 2020 | Pusch, Catharina |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

................................................................
& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

EP 20 18 6097

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2016/105622 A1 (TAMAKI TOKUHIKO [JP]) 14 avril 2016 (2016-04-14) * alinéa [0061] - alinéa [0069]; figures 6, 16 * * alinéas [0051], [0053], [0102], [0103] * * alinéas [0047], [0048], [0051] - [0053]; figures 4,5 * ----- | 7 | |
| Y | EP 3 209 012 A1 (SAMSUNG ELECTRONICS CO LTD [KR]) 23 août 2017 (2017-08-23) * alinéa [0104] - alinéas [0110], [0116]; figures 9A,9C * * alinéas [0049], [0068], [0091] * ----- | 6 | |

DOMAINES TECHNIQUES
RECHERCHES (IPC)

Le présent rapport a été établi pour toutes les revendications

| Lieu de la recherche | Date d'achèvement de la recherche | Examinateur |
|---|---|---|
| Munich | 26 octobre 2020 | Pusch, Catharina |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

&  : membre de la même famille, document correspondant

EPO FORM 1503 03.82 (P04C02)

page 2 de 2

**EP 3 767 677 A1**

**ANNEXE AU RAPPORT DE RECHERCHE EUROPEENNE**
**RELATIF A LA DEMANDE DE BREVET EUROPEEN NO.**

EP 20 18 6097

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-10-2020

| Document brevet cité au rapport de recherche | Date de publication | Membre(s) de la famille de brevet(s) | Date de publication |
|---|---|---|---|
| US 2017257587 A1 | 07-09-2017 | JP 2016058559 A<br>US 2017257587 A1<br>US 2019098239 A1<br>US 2020195869 A1<br>WO 2016039152 A1 | 21-04-2016<br>07-09-2017<br>28-03-2019<br>18-06-2020<br>17-03-2016 |
| EP 3579021 A1 | 11-12-2019 | EP 3579021 A1<br>JP WO2018142878 A1 | 11-12-2019<br>21-11-2019 |
| DE 102016102111 A1 | 18-08-2016 | CN 105898118 A<br>DE 102016102111 A1<br>JP 6709632 B2<br>JP 2016152417 A<br>KR 20160100569 A<br>US 2016240571 A1<br>US 2017358615 A1 | 24-08-2016<br>18-08-2016<br>17-06-2020<br>22-08-2016<br>24-08-2016<br>18-08-2016<br>14-12-2017 |
| US 2013182173 A1 | 18-07-2013 | BR 112014016988 A2<br>CN 104081245 A<br>CN 107197142 A<br>CN 107197143 A<br>CN 107197177 A<br>CN 107197178 A<br>CN 107197179 A<br>CN 107256876 A<br>EP 2804035 A1<br>JP 5556823 B2<br>JP 2013145292 A<br>KR 20140122723 A<br>KR 20170078871 A<br>RU 2014133174 A<br>US 2013182173 A1<br>US 2016219233 A1<br>US 2017223293 A1<br>US 2020236312 A1<br>WO 2013105481 A1 | 27-06-2017<br>01-10-2014<br>22-09-2017<br>22-09-2017<br>22-09-2017<br>22-09-2017<br>22-09-2017<br>17-10-2017<br>19-11-2014<br>23-07-2014<br>25-07-2013<br>20-10-2014<br>07-07-2017<br>10-03-2016<br>18-07-2013<br>28-07-2016<br>03-08-2017<br>23-07-2020<br>18-07-2013 |
| US 2016105622 A1 | 14-04-2016 | US 2016105622 A1<br>US 2018227527 A1<br>US 2019132540 A1<br>US 2019260954 A1 | 14-04-2016<br>09-08-2018<br>02-05-2019<br>22-08-2019 |
| EP 3209012 A1 | 23-08-2017 | CN 107105130 A<br>EP 3209012 A1<br>KR 20170098089 A<br>US 2017243367 A1 | 29-08-2017<br>23-08-2017<br>29-08-2017<br>24-08-2017 |

Pour tout renseignement concernant cette annexe : voir Journal Officiel de l'Office européen des brevets, No.12/82

page 1 de 2

**ANNEXE AU RAPPORT DE RECHERCHE EUROPEENNE
RELATIF A LA DEMANDE DE BREVET EUROPEEN NO.**

EP 20 18 6097

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

26-10-2020

| Document brevet cité au rapport de recherche | Date de publication | Membre(s) de la famille de brevet(s) | Date de publication |
|---|---|---|---|
| | | WO 2017142342 A1 | 24-08-2017 |

Pour tout renseignement concernant cette annexe : voir Journal Officiel de l'Office européen des brevets, No.12/82

page 2 de 2

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 102016102111
- US 2017257587 A
- US 2013182173 A
- US 2016105622 A
- EP 3209012 A